# EUROPEAN PATENT SPECIFICATION

(11) **EP 3 514 258 B1**
(45) Date of publication and mention of the grant of the patent: **19.08.2020**
(21) Application number: 18738385.6
(22) Date of filing: 25.04.2018
(51) Int. Cl.: C23C 16/02, C23C 16/24, C23C 16/455

(54) **METHOD FOR THE HYDROPHOBIZATION OF A SUBSTRATE**
VERFAHREN ZUR HYDROPHOBIERUNG EINES SUBSTRATS
PROCÉDÉ D'HYDROPHOBISATION D'UN SUBSTRAT

(30) Priority: 26.04.2017 RU 2017114565
(43) Date of publication of application: 24.07.2019
(73) Proprietor: Closed Joint Stock Company Research-Engineering Center "Incomsystem", Kazan, 420029 (RU)
(72) Inventor: MOROZOV, Georgii Sergeevich, Kazan 420124 (RU); BAKUSEV, Ruslan Yakhiyaevich, Kazan 420073 (RU)
(74) Representative: Eisenführ Speiser
(86) International application number: PCT/RU2018/000269
(87) International publication number: WO 2018/199810

(56) References cited:
- EP-B1- 1 181 095
- RU-A- 2015 128 392
- US-A1- 2002 119 327
- US-A1- 2004 175 579

## Description

### FIELD OF THE INVENTION

The present invention relates to a method of hydrophobizing a surface of metallic articles or articles made from other materials to protect them against corrosion by applying an amorphous silicon layer. The present invention can be used in gas-bearing systems for collection and storage of natural gas samples for substrate preparation (vessel for gas storage and supply piping) in product quality control systems in the oil and gas industry, in chemical analytical laboratories, in the manufacture of analytical instrumentation and chromatographs, in commercial metering units, in systems for measuring the quantity and quality of gas and liquefied hydrocarbon gases on main gas pipelines.

### BACKGROUND OF THE INVENTION

U.S. Patent No. 6,511,760 (IPC B65D 85/00, published on 28.01.2003) discloses a method for passivating an interior surface of a gas storage vessel to protect the surface against the corrosion, in which the interior surface of the vessel is first dehydrated, then the vessel is evacuated, a gas containing silicon hydride is introduced, the gas vessel is heated under pressure, wherein the gas is decomposed into constituent parts, and a silicon layer is deposited on the interior surface of the vessel. The duration of the deposition of silicon is controlled to prevent a formation of a silicon dust in the vessel. The vessel is then purged with an inert gas to remove the gas containing the silicon hydride. The method is carried out in several cycles until the whole surface of the vessel is covered with silicon. The vessel is emptied and cooled to room temperature.

The disadvantage of this method is the absence of the initial preparation stage of the vessel, which negatively affects the quality and reproducibility of the obtained coating, filling the vessel with pure silicon hydride increases the cost of the operation, and its use for purging the technological lines causes a release of an unreacted toxic feed, which has a negative effect on the environment.

RU patent No. 2079569 (IPC C23C 8/28, published on 20.05.1997) discloses a method of passivating an inner surface of a reactor subjected to coking and a reactor, wherein a surface coating is obtained by thermal decomposition of an organometallic silicon compound containing no oxygen and water in an inert medium selected from the group consisting of argon, helium, mixtures thereof, nitrogen, hydrogen.

A drawback of this method is the absence of an initial treatment step of the inner surface of the reactor, which leads to poor adhesion and peeling of the coating. The coating obtained by this method is black and sticky, which makes it difficult to clean the reactor.

U.S. patent application No. 2016/0211141 (IPC H01L 21/285, published on 21.06.2016) discloses an apparatus and a method of depositing an amorphous silicon film onto a substrate, wherein a gaseous silane, disilane, dichlorosilane are decomposed in a chamber of an apparatus to deposit the amorphous silicon film on the substrate. According to the invention, gaseous silane, disilane, dichlorosilane are mixed with an atmospheric gas comprising at least one of hydrogen and helium.

Further, EP patent application No. 0540084 (IPC B01J 19/00, published 05.05.1993) discloses a method of passivating the inner surface of reactor tubes subjected to coking by coating the inner surface of the tube with a thin layer of ceramic material that is deposited by a thermal deposition of a silicon-containing organometallic precursor in a gas phase. Said ceramic material essentially consists of a silicon carbide, silicon nitride, silicon carbonitride, or mixtures thereof.

RU2015128392 discloses a method of coating a substrate with amorphous silicon.

A disadvantage of the above mentioned methods is the absence of a stage of an initial preparation of the surfaces of the substrate, tube, as a result the adhesion of the coating to the substrate is low, and problems relating to peeling of the coating occur.

### SUMMARY OF THE INVENTION

The method of hydrophobizing a substrate according to the invention is defined in the appended claims.

The present invention relates to a method of hydrophobizing a substrate, the method comprising steps of:
a) preparation of at least one surface of the substrate, comprising:
   - cleaning at least one surface of the substrate with an organic solvent at a temperature of 25 °C to 35 °C,
   - treating said at least one surface of the substrate with a solution of a mineral acid at a temperature of 20 °C to 30 °C,
   - drying said at least one surface of the substrate in an inert gas atmosphere;
b) deposition of an amorphous silicon on at least one surface of the substrate.

According to one embodiment, proposed is the method, wherein the at least one surface of the substrate is cleaned at a temperature of from 28°C to 30°C.

According to one embodiment, proposed is the method, wherein treating the at least one surface of the substrate with the solution of the mineral acid comprises an activation of the at least one surface of the substrate.

According to one embodiment, proposed is the method, wherein the at least one surface of the substrate is treated with the solution of the mineral acid at a temperature of 25 °C.

According to one embodiment, proposed is the method, wherein drying the at least one surface of the substrate is carried out at a temperature of from 200°C to 300°C.

According to another embodiment, proposed is the method, wherein the step of deposition comprises decomposing a silicon precursor in the inert gas atmosphere at a temperature of 600°C to 1000°C for 3 to 240 minutes, wherein the inert gas is a carrier gas.

According to another embodiment, proposed is the method, wherein the silicon precursor is a silicon hydride.

According to yet another embodiment, proposed is the method, wherein the inert gas is selected from the group consisting of argon, helium, nitrogen, and mixtures of two or more thereof with hydrogen.

According to yet another embodiment, proposed is the method, wherein the silicon precursor is mixed with the inert gas, wherein an amount of the silicon precursor in the mixture is from 1% by volume to 30% by volume, preferably from 1% by volume to 10% by volume.

According to yet another embodiment, proposed is the method, wherein at least one surface represents an inner or outer surface of the substrate.

According to yet another embodiment, proposed is the method, wherein the concentration of the mineral acid in the solution of the mineral acid is 1 mol·L⁻¹.

According to yet another embodiment, proposed is the method, wherein the mineral acid is selected from the group consisting of hydrochloric acid, sulfuric acid, nitric acid, and mixtures of two or more thereof.

According to yet another embodiment, proposed is the method, wherein the deposition of the amorphous silicon is carried out on the inner and outer surfaces of the substrate sequentially in any order or on the inner and outer surfaces of the substrate simultaneously.

According to yet another embodiment, proposed is the method, wherein the organic solvent is a volatile organic solvent selected from the group consisting of ethanol or tert-butanol.

According to yet another embodiment, proposed is the method, wherein a gas mixture obtained after the step of decomposition of the silicon precursor is reused as the carrier gas after mixing with the inert gas in a ratio of 1:2.

According to yet another embodiment, proposed is the method, wherein the substrate is made of stainless steel or glass.

The technical object of the present invention is to improve the quality of the coating while reducing costs, including enhancing the strength and durability of the coating against mechanical action, and also obtaining a more uniform coating on the surfaces of the substrate. Further, the present invention provides a coating having a high wetting contact angle. The above-mentioned improved characteristics make it possible to achieve an improved reliability of measuring a humidity of a gas. Also, the present invention provides an increase in the overall efficiency of the hydrophobizing process of the surfaces of the substrate.

### DETAILED DESCRIPTION OF THE PREFERRED EMBODIMENTS

As it is mentioned above, there is a problem of improving the quality of the coating used for hydrophobizing the surfaces of substrates. Having studied this problem, the inventors of the present invention found that this problem can be solved by carrying out a step of preparation of the substrate surface(s) comprising cleaning the surface(s) with an organic solvent, treating the surface(s) with a solution of a mineral acid and drying the surface(s) in an inert atmosphere gas.

Surface cleaning.

The inventors of the present invention have found that treating the substrate surface(s) with an organic solvent provides a cleaning thereof from various kinds of contaminants, impurities, laminations, which in turn allows providing a coating having a greater uniformity on the surface(s) of the substrate, as well as greater durability and strength against mechanical action, since the coating of amorphous silicon precipitates directly on the surface of the substrate, rather than on undesirable impurities or laminations.

From the viewpoint of providing a better surface cleaning of the substrate, the surface treatment of the substrate with an organic solvent is preferably carried out at a temperature of from 25°C to 35°C for 10-30 minutes, more preferably at a temperature of from 28°C to 30°C. In one preferred embodiment of the invention, said cleaning with an organic solvent is carried out at a temperature of 29°C. The surface treatment of the substrate with an organic solvent is carried out at these temperatures, since the activity of the solvent in the above temperature ranges is optimal.

It has also been found that a volatile organic solvent is preferable for the cleaning step. Examples of such solvents are ethanol and tert-butanol.

Thus, cleaning the substrate surface with the use of the above mentioned temperatures, time range and solvent provides a better surface cleaning, which subsequently provides a more uniform, durable and reliable coating. Also, cleaning allows obtaining a surface that is convenient for a subsequent treatment with a solution of a mineral acid, and a surface that is cleaned in such a manner provides greater efficiency of subsequent treatment with the solution of the mineral acid.

Surface treatment with a solution of a mineral acid.

The inventors of the present invention have found that treating the surface(s) of the substrate with a solution of a mineral acid provides activation of the surface(s) for the subsequent deposition of an amorphous silicon layer. This activation of the surface of the substrate, firstly, reduces a content of oxides on the surface, which in turn improves the purity of the resulting coating, secondly, by removing the oxide layer, it increases a density of the obtained coating and reduces the diffusion of the deposited silicon into the thickness of the substrate to be coated, and, thirdly, it provides reducing the surface roughness, and thereby providing an increase of the adhesion of the amorphous silicon to the surface of the substrate.

From the viewpoint of improving the surface activation efficiency, it is preferable to treat the surface with the solution of the mineral acid at a temperature of 20 to 30°C for 30-60 minutes. In one embodiment, the treatment is carried out at a temperature of 25°C.

It has also been found that for the indicated cleansing process it is preferable to use an aqueous solution of the mineral acid with an acid concentration of 1 mol·L⁻¹. Examples of mineral acids are hydrochloric acid, sulfuric acid, nitric acid. These acids can be used alone or in a mixture of two or more thereof.

The inventors have found that the advantageous activation is achieved by activating the surface of the substrate with the use of the indicated temperature and time ranges and indicated concentration of the indicated mineral acid(s), since compliance with these conditions results in a low concentration of oxides on the surface of the substrate and a low roughness providing an increased level of adhesion of the layer of amorphous silicon to the surface of the substrate while maintaining the uniformity of the layer.

Drying the surface.

Drying the surface(s) of the substrate is carried out after carrying out cleaning with the organic solvent and treating the surface(s) with the solution of the mineral acid. This drying is necessary to remove the remaining amounts of the organic solvent and the mineral acid solution.

From the viewpoint of effective removal of the remaining amounts of the organic solvent and solution of the mineral acid, drying should be carried out at a temperature of 200 to 300°C for 10-30 minutes. Additionally, the inventors have discovered that drying in the indicated temperature and time ranges provides maintaining the low surface roughness obtained in the activation step (by treating with the solution of the mineral acid) in a required optimal condition, which provides the necessary adhesion between the amorphous silicon layer and the substrate surface. Further, after performing studies, it has been discovered that the preferable drying is carried out in an inert gas atmosphere, because unlike conventional air drying, there is no moisture in the inert gas stream that can condense on the surface of the substrate, which can have undesirable effect on the quality of the obtained coating of amorphous silicon, and there is no oxygen in the inert gas stream, which can interact with the substrate to form oxides negatively affecting the quality of the obtained coating. Argon, helium, nitrogen and mixtures of two or more of them with hydrogen can be used as the inert gas.

In some embodiments, the drying step may be preceded by one or more substrate washing operations conducted between and/or after the respective cleaning and activating steps. The washing is carried out, for example, with distilled water.

Also, in a preferred embodiment, the drying is preferably carried out with the same inert gas or mixture of gases that is provided as the carrier gas for the silicon precursor. The fact that the drying is carried out by the same inert gas facilitates a rapid adaptation (sensitization) of the substrate to a feed mixture of the precursor and the carrier gas, which in turn ensures a more even and uniform coating.

Precipitation of amorphous silicon.

The deposition of an amorphous silicon layer on the surface(s) of the substrate represents a step of feeding the silicon precursor in a mixture with an inert gas to the substrate surface(s), followed by the decomposition of this silicon precursor upon heating.

The silicon precursor can be any silicon-containing compound that, upon thermal decomposition, provides release of the amorphous silicon. Preferably, the silicon precursor is a silicon hydride. However, it should be noted that this passage does not exclude use of other compounds that release amorphous silicon upon decomposition. Thus, for example, said silicon hydride may be optionally substituted with C₁-C₆ alkyl groups, halogens, amino groups, etc. In general, when selecting the silicon precursor, one should observe the condition that the indicated silicon precursor should evaporate with the release of the amorphous silicon at a temperature below 600°C.

The aforementioned condition for selecting a silicon precursor is a consequence of the fact that the inventors have found that the most effective temperature for depositing the amorphous silicon layer is from 600°C to 1000°C with a time for depositing of from 3 to 240 minutes. As indicated above, the deposition of the amorphous silicon on the surface of the substrate represents a thermal decomposition reaction of the precursor of the amorphous silicon.

The silicon precursor is fed in the inert gas atmosphere onto the surface of the substrate. In this case, the inert gas acts as the carrier gas transporting the indicated silicon precursor. Argon, helium, nitrogen and mixtures of two or more of them with hydrogen can be used as the inert gas.

The silicon precursor is mixed with the inert gas such that an amount of the silicon precursor in the mixture is from 1% by volume to 30% by volume, preferably from 1% by volume to 10% by volume. It should be noted that the amount of the silicon precursor depends on a specific technological process, conditions of the process, required results and etc. However, it has been found by the inventors that the above mentioned amount of the silicon precursor in the mixture with the inert gas provides the most efficient use of the precursor, such that a major part of the precursor fed onto the surface of the substrate is deposited by the decomposition reaction.

When depositing the amorphous silicon on the surface of the substrate, this surface may represent an inner and/or outer surface of the substrate. The step of deposition of the layer of the amorphous silicon can be carried out both simultaneously on the inner and outer surfaces, and sequentially in any order. The above-mentioned steps of cleaning with the organic solvent and treating with the solution of the mineral acid can also be carried out simultaneously on both the inner and outer surfaces, and sequentially in any order.

The mixture of gases obtained after the deposition step, i.e. after decomposition of the silicon precursor, can be reused as the carrier gas and fed onto the substrate, said gas mixture is mixed with the inert gas in a ratio of 1:2 before feeding to the substrate. Thus, the gas mixture obtained after the step of deposition is mixed with the inert gas, followed by mixing with the silicon precursor, and then again fed to the substrate. This reuse of the gas mixture in the indicated ratio (ratio of the mixture of gases after deposition to the inert gas as 1:2) makes it possible to increase the overall deposition efficiency, at this ratio substantially all precursor is used, i.e. at this ratio almost all silicon precursor remained unreacted after the decomposition reaction is deposited on the surface of the substrate. Also, it should be noted that this reuse allows one to carry out the process in a rational way, thereby reducing the cost of the operation of coating the surface and reducing unwanted emissions.

It should be noted that the indicated deposition step can be carried out in several stages to achieve the required thickness of the amorphous silicon layer, wherein between the aforementioned deposition steps, the substrate can be purged with the inert gas stream. Preferably, the thickness of the amorphous silicon layer is from 100 to 2000 nm.

A material of the substrate is not limited in any specific manner. Thus, the material can be a metallic material such as iron, titanium, aluminum, nickel, copper, stainless steel; material made of glass, ceramics. In a preferred embodiment, the substrate material is stainless steel or glass.

### Example 1.

The substrate was a stainless steel pipe. The inner and outer surfaces of the pipe were cleaned with ethanol at a temperature of 29°C for 10 minutes, then both surfaces were washed with distilled water. Next, the pipe surfaces were treated with a 1M solution of HNO₃ at a temperature of 25°C for 30 minutes and then again washed with distilled water. The surface of the pipe was then dried with a stream of gaseous nitrogen at a temperature of 200°C. The cleaned dry pipe was introduced into an apparatus for hydrophobization and connected to a corresponding tube for feeding a gaseous mixture into the inner part of the pipe and a corresponding tube for feeding a gaseous mixture onto the outer surface of the pipe. The gaseous mixture containing silicon hydride and a mixture of argon and helium was supplied to the inner part of the tube and onto the outer surface of the pipe with the amount of silicon hydride of 20% by volume. The feed of the gaseous mixture was adjusted by means of adjusting valves. After the stable flow mode of the gas mixture was reached, an induction heater was turned on, and the pipe surfaces were heated to 600 °C by induction heating. The pipe was aged at this temperature for about 5 minutes. After five minutes, the inner part of the pipe and the outer surface of the pipe were purged with a stream of argon and helium. The process was repeated for 4 times to obtain a thickness of a coating of 400 nm.

### Example 2.

The process was carried out in the same manner as in Example 1, except that the mixture of gases after aging was again directed to the inner part of the pipe and onto the outer surface after mixing with the inert gas (mixture of argon and helium) at a ratio of "inert gas:silicon hydride " of 1: 2 and mixing with a further amount of silicon hydride.

### Example 3.

The process was carried out in the same manner as in Example 1, except that the deposition was first carried out on the inner part of the pipe and then onto the outer surface of the pipe.

The coatings obtained in the examples greatly reduced an ability of the surfaces of the cylinder to be wetted by water and aqueous solutions. Also, the resulting surfaces of the amorphous silicon layer had good uniformity and high durability.

The proposed invention improves the quality of the protective coating layer and can find application in apparatuses for preparation of a vessel for storing a sample of natural gas and in apparatuses for preparation of a gas supply pipeline when sampling natural gas in quality control systems in the oil and gas industry, in commercial metering units, in chemical analytical laboratories, in the production of analytical instrumentation and chromatographs, in systems for measuring the quantity and quality of gas and liquefied hydrocarbon gases on main gas pipelines.

## Claims

1. A method of hydrophobizing a substrate, the method comprising steps of:
a) preparation of at least one surface of the substrate, comprising:
- cleaning at least one surface of the substrate with an organic solvent at a temperature of 25 °C to 35 °C,
- treating said at least one surface of the substrate with a solution of a mineral acid at a temperature of 20°C to 30°C,
- drying said at least one surface of the substrate in an inert gas atmosphere;
b) deposition of an amorphous silicon on at least one surface of the substrate.

2. The method of claim 1, wherein said at least one surface of the substrate is cleaned at a temperature of from 28°C to 30°C.

3. The method of claim 1, wherein treating said at least one surface of the substrate with the solution of the mineral acid comprises an activation of said at least one surface of the substrate before deposition.

4. The method of claim 1, wherein said at least one surface of the substrate is treated with the solution of the mineral acid at a temperature of 25°C.

5. The method of claim 1, wherein drying said at least one surface of the substrate is carried out at a temperature of from 200°C to 300°C.

6. The method of claim 1, wherein the step of deposition comprises decomposing a silicon precursor in the inert gas atmosphere at a temperature of 600°C to 1000°C for 3 to 240 minutes, wherein the inert gas is a carrier gas.

7. The method of claim 1, wherein the silicon precursor is a silicon hydride.

8. The method of claim 1 or 5, wherein the inert gas is selected from the group consisting of argon, helium, nitrogen, and mixtures of two or more thereof with hydrogen.

9. The method of claim 5, wherein the silicon precursor is mixed with the inert gas, wherein an amount of the silicon precursor in the mixture is from 1% by volume to 30% by volume, wherein the amount of the silicon precursor is preferably from 1% by volume to 10% by volume.

10. The method of claim 1, wherein at least one surface represents an inner and/or outer surface of the substrate.

11. The method of claim 1, wherein the concentration of the mineral acid in the solution of the mineral acid is 1 mol·L⁻¹ or wherein the mineral acid is selected from the group consisting of hydrochloric acid, sulfuric acid, nitric acid, and mixtures of two or more thereof.

12. The method of claim 10, wherein the deposition of the amorphous silicon is carried out on the inner and outer surfaces of the substrate sequentially in any order.

13. The method of claim 10, wherein the deposition of amorphous silicon is carried out on the inner and outer surfaces of the substrate simultaneously.

14. The method of claim 1, wherein the organic solvent is a volatile organic solvent or wherein the solvent is ethanol or tert-butanol.

15. The method of claim 6, wherein a gas mixture obtained after the step of decomposition of the silicon precursor is reused as the carrier gas after mixing with the inert gas in a ratio of 1:2, wherein the substrate is preferably made of stainless steel or glass.

## Patentansprüche

1. Verfahren zur Hydrophobierung eines Substrats, umfassend die Schritte:
a) Vorbereitung zumindest einer Oberfläche des Substrats, auf dem:
- die zumindest eine Oberfläche des Substrats mit einem organischen Lösungsmittel bei einer Temperatur von 25°C bis 35°C gereinigt wird,
- die zumindest eine Oberfläche des Substrats mit einer Mineralsäurelösung bei einer Temperatur von 20°C bis 30°C behandelt wird,
- die zumindest eine Oberfläche des Substrats in einer Inertgasatmosphäre getrocknet wird;
b) Abscheidung von amorphem Silizium auf der zumindest einen Oberfläche des Substrats.

2. Verfahren nach Anspruch 1, wobei die zumindest eine Oberfläche des Substrats bei der Temperatur von 28°C bis 30°C gereinigt wird.

3. Verfahren nach Anspruch 1, wobei die Behandlung der zumindest einen Oberfläche des Substrats mit einer Mineralsäurelösung eine Aktivierung der zumindest einen Oberfläche des Substrats vor der Abscheidung ist.

4. Verfahren nach Anspruch 1, wobei die zumindest eine Oberfläche des Substrats mit der Mineralsäurelösung bei der Temperatur von 25°C behandelt wird.

5. Verfahren nach Anspruch 1, wobei die zumindest eine Oberfläche des Substrats bei einer Temperatur von 200°C bis 300°C getrocknet wird.

6. Verfahren nach Anspruch 1, wobei der Abscheidungsschritt die Zersetzung eines Siliziumvorläufers in der Inertgasatmosphäre bei einer Temperatur von 600°C bis 100°C während 3 bis 240 Minuten umfasst, wobei das Inertgas ein Trägergas ist.

7. Verfahren nach Anspruch 1, wobei der Siliziumvorläufer Siliziumhydrid ist.

8. Verfahren nach Anspruch 1 oder 5, wobei das Inertgas aus der Gruppe ausgewählt ist, bestehend aus Argon, Helium, Stickstoff und Gemischen von zwei oder mehreren davon mit Wasserstoff.

9. Verfahren nach Anspruch 5, wobei der Siliziumvorläufer mit dem Inertgas gemischt wird, wobei der Gehalt des Siliziumvorläufers in der Mischung von 1 Vol.-% bis 30 Vol.-% beträgt, wobei der Gehalt des Siliziumvorläufers bevorzugt von 1 Vol.-% bis 10 Vol.-% beträgt.

10. Verfahren nach Anspruch 1, wobei die zumindest eine Oberfläche eine innere und/oder äußere Oberfläche des Substrats ist.

11. Verfahren nach Anspruch 1, wobei die Konzentration der Mineralsäure in der Mineralsäurelösung 1 mol^{∗}l⁻¹ beträgt oder
wobei die Mineralsäure aus der Gruppe ausgewählt ist, bestehend aus Salzsäure, Schwefelsäure, Salpetersäure und Gemischen von zwei oder mehreren davon.

12. Verfahren nach Anspruch 10, wobei die Abscheidung von amorphem Silizium auf die innere und äußere Oberfläche des Substrats nacheinander in beliebiger Reihenfolge durchgeführt wird.

13. Verfahren nach Anspruch 10, wobei die Abscheidung von amorphem Silizium auf die innere und äußere Oberfläche des Substrats gleichzeitig durchgeführt wird.

14. Verfahren nach Anspruch 1, wobei das organische Lösungsmittel ein leichtflüchtiges organisches Lösungsmittel ist oder wobei das Lösungsmittel Ethylalkohol oder tert-Butanol ist.

15. Verfahren nach Anspruch 6, wobei ein Gasgemisch, das sich nach dem Zersetzungsschritt des Siliziumvorläufers ergibt, als Trägergas beim Mischen mit dem Inertgas im Verhältnis 1:2 wiederverwendet wird, wobei das Substrat vorzugsweise aus rostfreiem Stahl oder Glas ausgebildet ist.

## Revendications

1. Procédé d'hydrophobisation d'un substrat, le procédé comprenant des étapes suivantes:
a) préparation d'au moins une surface du substrat comprenant
- nettoyage d'au moins une surface du substrat avec un solvant organique à des températures de 25°C à 35°C,
- traitement de ladite au moins une surface du substrat avec une solution d'un acide minéral à des températures de 20°C à 30°C,
- séchage de ladite une surface du substrat dans une atmosphère d'un gaz inerte ;
b) dépôt du silicium amorphe sur au moins une surface du substrat.

2. Procédé selon la revendication 1, dans lequel ladite au moins une surface du substrat est nettoyée à des températures de 28°C à 30°C.

3. Procédé selon la revendication 1, dans lequel le traitement de ladite au moins une surface du substrat avec une solution d'un acide minéral comprend une activation de ladite au moins une surface du substrat avant le dépôt.

4. Procédé selon la revendication 1, dans lequel ladite au moins une surface du substrat est traitée avec une solution d'un acide minéral à une température de 25°C.

5. Procédé selon la revendication 1, dans lequel le séchage de ladite au moins une surface du substrat est effectué à des températures de 200°C à 300°C.

6. Procédé selon la revendication 1, dans lequel l'étape de dépôt comprend une décomposition d'un précurseur de silicium dans l' atmosphère d'un gaz inerte à des températures de 600°C à 1000°C pendant 3 à 240 minutes, le gaz inerte étant un gaz porteur.

7. Procédé selon la revendication 1, dans lequel le précurseur de silicium est un hydrure de silicium.

8. Procédé selon la revendication 1 ou 5, dans lequel le gaz inerte est choisi du groupe consistant de l'argon, l'hélium, le nitrogène et de mixtures de deux ou plus d'eux avec l'hydrogène.

9. Procédé selon la revendication 5, dans lequel le précurseur de silicium est mixé avec le gaz inerte, la quantité du précurseur de silicium dans la mixture étant de 1% en volume à 30% en volume, la quantité du précurseur de silicium étant préférablement de 1% en volume à 10% en volume.

10. Procédé selon la revendication 1, dans lequel au moins une surface représente une surface intérieur et/ou une surface extérieure du substrat.

11. Procédé selon la revendication 1, dans lequel la solution de l'acide minéral est 1 mol·L⁻¹ ou dans lequel l'acide minéral est choisi du groupe consistant de l'acide hydrochlorique, l'acide sulfurique, l'acide nitriqie et de mixtures de deux ou plus d'eux.

12. Procédé selon la revendication 10, dans lequel le dépôt du silicium amorphe est effectué sur la surface intérieure et la surface extérieure du substrat séquentiellement dans n'importe quel ordre.

13. Procédé selon la revendication 10, dans lequel le dépôt du silicium amorphe est effectué sur la surface intérieure et la surface extérieure du substrat simultanément.

14. Procédé selon la revendication 1, dans lequel le solvant organique est un solvant organique volatil ou dans lequel le solvant est éthanol ou tert-butanol.

15. Procédé selon la revendication 6, dans lequel une mixture des gaz obtenue après l'étape de décomposition du précurseur de silicium est reutilisée en tant que le gaz porteur après son mixage avec un gaz inerte dans un rapport de 1:2, le substrat étant préférablement fait d'acier inoxidable ou verre.
